# EUROPEAN PATENT APPLICATION

(11) **EP 4 730 923 A1**
(43) Date of publication of application: **22.04.2026**
(21) Application number: 25205101.6
(22) Date of filing: 26.09.2025
(51) Int. Cl.: H05K 1/11, H05K 1/14, H01M 10/42, H05K 1/189, H05K 3/306

(54) **FLEXIBLE PRINTED CIRCUIT BOARD ASSEMBLY, BATTERY MODULE INCLUDING THE SAME AND METHOD OF MANUFACTURING THE FLEXIBLE PRINTED CIRCUIT BOARD ASSEMBLY**

(30) Priority: 15.10.2024 KR 20240140649
(71) Applicant: SAMSUNG SDI CO., LTD., Yongin-si, Gyeonggi-do 17084 (KR)
(72) Inventor: LEE, Hyeok, 17084 YONGIN-SI (KR)
(74) Representative: Regimbeau

(57) **Abstract**

One or more embodiments of the present disclosure provides a manufacturing method for a flexible printed circuit board assembly (40) including a first substrate (410) including a first main line (4110), a first branch line (4130) extending from the first main line, and a first connector (4150) at a first side of the first main line, and having a perforation (4151), and a second substrate (430) separated from the first substrate (410), and including a second main line (4310), a second branch line (4330) extending from the second main line, and a second connector (4350) at a first side of the second main line, and having a perforation (4351), wherein the first substrate (410) and the second substrate (430) are electrically connected through the first connector (4150) and the second connector (4350).

## Description

### TECHNICAL FIELD

The present disclosure relates to a flexible printed circuit board assembly, a battery module including the same, and a manufacturing method for the flexible printed circuit board.

### BACKGROUND

A rechargeable battery differs from a primary battery in that it can be repeatedly charged and discharged, while the latter is incapable of being recharged. Low-capacity rechargeable batteries are used in relatively small, portable electronic devices, such as smartphones, feature phones, laptop computers, digital cameras, and camcorders, while large-capacity rechargeable batteries are widely used as power sources for driving motors in hybrid vehicles, electric vehicles, and as power storage batteries.

A plurality of battery cells for rechargeable batteries may be provided, and may be connected in series and/or in parallel through connecting members, such as busbars, to form a battery module.

The battery module may include a flexible printed circuit board electrically connected to each battery cell to measure information related to the battery cell (e.g., voltage information and current information), and to transmit that information to an outside.

A shape of the flexible printed circuit board may vary depending on a shape and arrangement of the battery cells. For example, a length of the flexible printed circuit board may be determined according to an arrangement length (or stacking length) of the battery cells, and a width of the flexible printed circuit board may be determined according to a distance between electrode terminals arranged on the battery cells.

Each battery cell may be stacked in a direction, and electrode terminals arranged in the same battery cell may be spaced apart from each other by a corresponding distance. Herein, the distance between the electrode terminals of each battery cell may be made a same size. For example, arrangement of the electrode terminals in the battery module in which battery cells are stacked in the direction may be formed in two rows spaced apart by an equal distance.

The flexible printed circuit board may include components that allow for connection to the electrode terminals of each spaced battery cell. The components may be spaced apart from each other by a distance corresponding to the distance between the electrode terminals arranged in the same battery cell, and accordingly, the width of the flexible printed circuit board may also be fixed.

If the width of the flexible printed circuit board is fixed along a longitudinal direction of the flexible printed circuit board (same direction as the stacking direction of the battery cells), unusable scrap parts may be generated in materials used in manufacturing the flexible printed circuit board, which may affect an efficiency and cost of manufacturing the flexible printed circuit board.

However, the present disclosure is not limited to the objects mentioned above, and other aspects not mentioned can be clearly understood by those skilled in the art from the description of the claims.

### SUMMARY

The present disclosure attempts to reduce or minimize a waste space that may occur during manufacture of a flexible printed circuit board.

However, the present disclosure is not limited to the above, and other aspects not mentioned can be clearly understood by those skilled in the art from the description of the claims.

The invention relates to a flexible printed circuit board assembly, a battery module and a manufacturing method for a flexible printed circuit board assembly as defined in the appended claims.

One or more embodiments of the present disclosure provide a flexible printed circuit board assembly including a first substrate including a first main line, a first branch line extending from the first main line, and a first connector at a first side of the first main line, and having a perforation, and a second substrate separated from the first substrate, and including a second main line, a second branch line extending from the second main line portion, and a second connector at a first side of the second main line, and having a perforation, wherein the first substrate and the second substrate are electrically connected through the first connector and the second connector.

The flexible printed circuit board assembly may further include a receptacle including pins configured to be received in the perforation of the first connector and in the perforation of the second connector.

The flexible printed circuit board assembly may further include a fixing member having a first surface on which the first connector and the second connector are arranged, and a second surface to which the receptacle is connected.

The fixing member may include a rigid printed circuit board.

The fixing member may include an adhesive between the fixing member and the first connector, and between the fixing member and the second connector.

The fixing member may define throughholes corresponding to the perforation, wherein the pins extend through the throughholes beyond the first connector and the second connector.

The first substrate and the second substrate may include a base film having an insulating property and flexibility, and a circuit pattern layer on a first surface of the base film.

The flexible printed circuit board assembly may further include a wire assembly in the receptacle.

One or more embodiments of the present disclosure provides a battery module including a flexible printed circuit board assembly including a first substrate including a first main line, a first branch line extending from the first main line, and a first connector at a first side of the first main line, and having a perforation, and a second substrate separated from the first substrate, and including a second main line, a second branch line extending from the second main line portion, and a second connector at a first side of the second main line, and having a perforation, wherein the first substrate and the second substrate are electrically connected through the first connector and the second connector.

One or more embodiments of the present disclosure provides a manufacturing method for a flexible printed circuit board assembly, the method including separately manufacturing a first substrate including a first connector at a first side, and a second substrate including a second connector at a first side, and electrically connecting the first substrate and the second substrate through the first connector and the second connector.

The electrically connecting the first substrate and the second substrate may include arranging the first connector and the second connector on a first surface of a fixing member, and connecting a receptacle to a second surface of the fixing member

The electrically connecting the first substrate and the second substrate may further include inserting a wire assembly into the receptacle.

According to the present disclosure, a number of flexible printed circuit board assemblies that can be manufactured from a same material may be increased.

A flexible printed circuit board assembly is formed of a single layer, so a pin connection structure with a wire assembly may be simplified, and interference between internal circuits of the flexible printed circuit board assembly may be suppressed.

However, the present disclosure is not limited to the above, and other technical aspects not mentioned can be clearly understood by those skilled in the art from the description of the claims.

### BRIEF DESCRIPTION OF THE DRAWINGS

The following drawings attached to this specification illustrate embodiments of the present disclosure, and together with the detailed description of the disclosure described later, serve to further understand the technical idea of the present disclosure, and thus the present disclosure should not be construed as limited to only the matters depicted in such drawings.
FIG. 1 illustrates a top view of a busbar assembly including a flexible printed circuit board assembly according to one or more embodiments of the present disclosure.
FIG. 2 illustrates a perspective view of the flexible printed circuit board assembly of FIG. 1.
FIG. 3 illustrates a bottom view of the flexible printed circuit board assembly of FIG. 2.
FIG. 4 illustrates a partial cross-sectional view of either a first substrate or a second substrate.
FIG. 5 illustrates an information transmission path in a flexible printed circuit board assembly.
FIG. 6 illustrates a schematic view for describing the number of first substrates that can be manufactured from a material having a corresponding size.
FIG. 7 illustrates a schematic view for describing the number of second substrates that can be manufactured with a material of a same size as that of FIG. 6.
FIG. 8 illustrates a schematic view for describing the number of general flexible printed circuit boards that can be manufactured with a material having a same size as that of FIG. 6.
FIG. 9 illustrates a flowchart for describing a manufacturing method for a flexible printed circuit board assembly according to one or more embodiments of the present disclosure.
FIG. 10 illustrates a flowchart for describing in more detail an operation of electrically connecting the first substrate and the second substrate of FIG. 9.
FIG. 11 is a view illustrating an operation of arranging a first connector and a second connector on a first surface of a fixing member.
FIG. 12 is a view illustrating an operation of connecting a receptacle to a second surface of the fixing member.
FIG. 13 is a view illustrating an operation of inserting a wire assembly into a receptacle.

### DETAILED DESCRIPTION

Aspects of some embodiments of the present disclosure and methods of accomplishing the same may be understood more readily by reference to the detailed description of embodiments and the accompanying drawings. The described embodiments are provided as examples so that this disclosure will be thorough and complete, and will fully convey the aspects of the present disclosure to those skilled in the art. Accordingly, processes, elements, and techniques that are redundant, that are unrelated or irrelevant to the description of the embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present disclosure.

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

In the drawings, the relative sizes of elements, layers, and regions may be exaggerated for clarity and/or descriptive purposes. In other words, because the sizes and thicknesses of elements in the drawings are arbitrarily illustrated for convenience of description, the disclosure is not limited thereto. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result of, for example, manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the illustrated shapes of elements, layers, or regions, but are to include deviations in shapes that result from, for instance, manufacturing.

Spatially relative terms, such as "beneath," "below," "lower," "lower side," "under," "above," "upper," "over," "higher," "upper side," "side" (e.g., as in "sidewall"), and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below," "beneath," "or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include stack, face or facing, extending over, covering, or partly covering or any other suitable term as would be appreciated and understood by those of ordinary skill in the art. The expression "not overlap" may include meaning, such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

It will be understood that when an element, layer, region, or component (e.g., an apparatus, a device, a circuit, a wire, an electrode, a terminal, a conductive film, etc.) is referred to as being "formed on," "on," "connected to," or "(operatively, functionally, or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a transistor, a resistor, an inductor, a capacitor, a diode and/or the like. Accordingly, a connection is not limited to the connections illustrated in the drawings or the detailed description and may also include other types of connections. In describing embodiments, an expression of connection indicates electrical connection unless explicitly described to be direct connection, and "directly connected/directly coupled," or "directly on," refers to one component directly connecting or coupling another component, or being on another component, without an intermediate component.

In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components, such as "between," "immediately between" or "adjacent to" and "directly adjacent to," may be construed similarly. It will be understood that when an element or layer is referred to as being "between" two elements or layers, it can be the only element or layer between the two elements or layers, or one or more intervening elements or layers may also be present.

For the purposes of this disclosure, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XY, YZ, and XZ, or any variation thereof. Similarly, the expressions "at least one of A and B" and "at least one of A or B" may include A, B, or A and B. As used herein, "or" generally means "and/or," and the term "and/or" includes any and all combinations of one or more of the associated listed items. For example, the expression "A and/or B" may include A, B, or A and B. Similarly, expressions such as "at least one of," "a plurality of," "one of," and other prepositional phrases, when preceding a list of elements, modify the entire list of elements and do not modify the individual elements of the list. When "C to D" is stated, it means C or more and D or less, unless otherwise specified.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are only used to distinguish one element, member, component, region, area, layer, section, or portion from another element, member, component, region, area, layer, section, or portion. Thus, a first element, component, region, layer or section described below could be termed a second element, component, region, layer or section, without departing from the scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or secondset)," etc., respectively.

The terminology used herein is for the purpose of describing embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

When one or more embodiments may be implemented differently, a specific process order may be performed differently from the described order. For example, two consecutively described processes may be performed substantially at the same time or performed in an order opposite to the described order.

As used herein, the terms "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure." Furthermore, the expression "being the same" may mean "being substantially the same". In other words, the expression "being the same" may include a range that can be tolerated by those of ordinary skill in the art. The other expressions may also be expressions from which "substantially" has been omitted.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

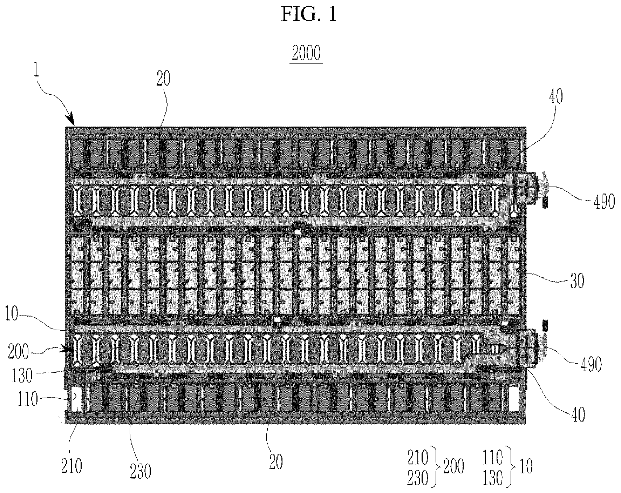

FIG. 1 illustrates a top view of a battery module 2000 according to one or more embodiments of the present disclosure. The battery module 2000 may include a plurality of battery cells 200 stacked along a direction and a busbar assembly 1 arranged on the battery cells 200.

The battery cells 200 may be arranged in a plurality of rows (e.g., two rows in the one or more embodiments corresponding to FIG. 1), and may be configured as a stack.

Referring to FIG. 1, the busbar assembly 1 may include a busbar holder 10, a busbar 20 electrically connecting battery cells 200 that are adjacent to each other and that are arranged in a same row, a center busbar 30 electrically connecting battery cells 200 arranged in different rows, and a flexible printed circuit board assembly 40.

The busbar holder 10 may be made of an insulating material. The busbar holder 10 may block unnecessary or undesirable electrical connections between the battery module 2000 and external components (e.g., an electrical connection that is not intended by a user).

The busbar holder 10 may have, or may define, a first opening 110 exposing the electrode terminals 210 of the battery cells 200, and a second opening 130 positioned to correspond to a position of a vent 230 of each of the battery cells.

A busbar 20 may be positioned on (or within) the first opening 110, and an electrode terminal 210 exposed through the first opening 110 may be connected to the busbar 20. The busbar 20 may be positioned to connect two adjacent electrode terminals 210 so as to electrically connect the adjacent electrode terminals 210. The busbar 20 may be made of a conductive material.

For example, if the electrode terminals 210 of a same polarity are arranged on a same line, the battery cells 200 may be connected in series through the busbar 20, and if the electrode terminals 210 of different polarities may be arranged alternately on a same line, the battery cells 200 may be connected in parallel through the busbar 20. The present disclosure is not limited thereto, and the battery cells 200 may be arranged in a mixed series and parallel connection.

In one or more embodiments, the battery cells 200 may be electrically connected to other battery cells 200 arranged in other rows through the center busbar 30. For example, among the electrode terminals 210 of the battery cells 200 arranged in different rows, the electrode terminals 210 at an adjacent side to the center busbar 30 may be connected to each other through the center busbar 30. In one or more embodiments, parallel connection as well as series connection may be possible.

The flexible printed circuit board assembly 40 may be electrically connected to various electronic devices (e.g., a temperature sensor and a Heavy Duty Connector (HDC) terminal). The flexible printed circuit board assembly 40 may also be connected to the busbar 20 and the center busbar 30. The flexible printed circuit board assembly 40 may be electrically connected to the battery cell through the busbar 20, and may transmit information related to the battery cells (e.g., voltage information and current information) to an outside.

Connection between the flexible printed circuit board assembly 40 and the busbar 20 may be made indirectly through a nickel tab, or may be made directly through welding. In one or more embodiments, the flexible printed circuit board assembly 40 may be electrically connected to the outside through a wire assembly 490.

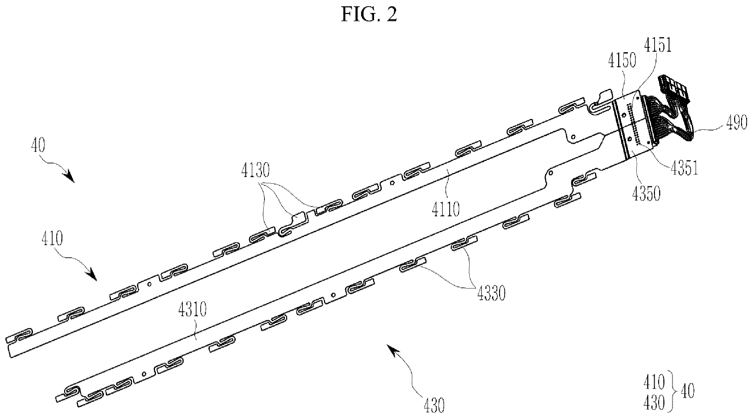

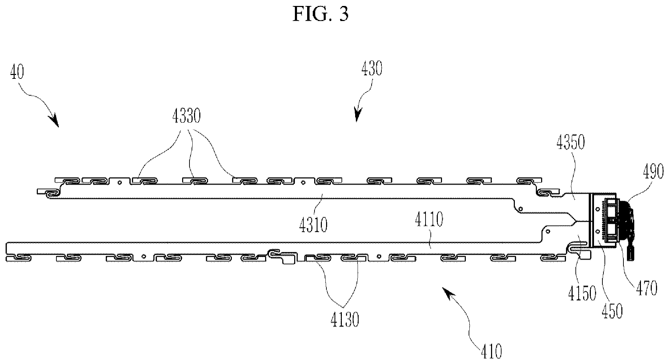

FIG. 2 illustrates a perspective view of the flexible printed circuit board assembly 40 of FIG. 1, and FIG. 3 illustrates a bottom view of the flexible printed circuit board assembly 40 of FIG. 2.

Referring to FIGS. 2 and 3, the flexible printed circuit board assembly 40 may include a flexible first printed circuit board 410 (hereinafter, referred to as a first substrate for convenience), and a flexible second printed circuit board 430 (hereinafter referred to as a second substrate for convenience) having a different shape from the first substrate 410.

The first substrate 410 may include a first main line 4110, a plurality of first branch lines 4130 extending from the first main line 4110, and a first connector 4150 positioned at a first side of the first main line 4110.

The first main line 4110 may be configured to extend along a stacking direction of the battery cells on the busbar holder 10. The first branch line 4130 may be configured to extend from the first main line 4110 in a direction toward an electronic device, the busbar 20, or the center busbar 30. The first substrate 410 may be electrically connected to the elements through the first branch lines 4130.

The second substrate 430 may also include a second main line 4310, a second branch line 4330, and a second connector 4350, which may be arranged similarly to components of the first substrate 410. However, a shape of the second substrate 430 may be different from that of the first substrate 410. For example, a length of the second main line 4310 or a number and arrangement of the second branch lines 4330 may be different from those of the first main line 4110 and the first branch line 4130.

The first substrate 410 and the second substrate 430 may be arranged such that the respective branch lines 4130 and 4330 face outwardly, rather than being between the respective substrates 410 and 430 for electrical connection therebetween. The first connector 4150 and the second connector 4350 may be arranged such that they are adjacent to each other.

The first substrate 410 and the second substrate 430 may be electrically connected to each other through the first connector 4150 and the second connector 4350. The connectors 4150 and 4350 may have perforations 4151 and 4351, respectively.

Insides of, or interiors of, the perforations 4151 and 4351 may be plated with an insulating material, so if a conductive material is received in the perforations 4151 and 4351, a current may flow between the conductive material and each of the connectors 4150 and 4350.

The flexible printed circuit board assembly 40 may further include a fixing member 450 that has a first surface on which the first connector 4150 and the second connector 4350 are arranged, and that is capable of providing fixed positions of the first connector 4150 and the second connector 4350, and also may include a receptacle 470 arranged on a second surface of the fixing member 450. Detailed descriptions of the fixing member 450 and the receptacle 470 will be provided later.

The wire assembly 490 may be accommodated in the receptacle 470, and the flexible printed circuit board assembly 40 may be electrically connected to an external device through the wire assembly 490. For example, the wire assembly 490 may be a wire harness.

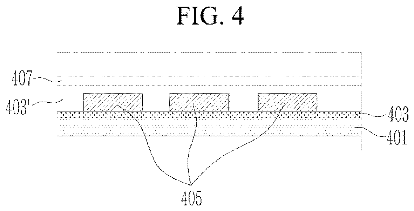

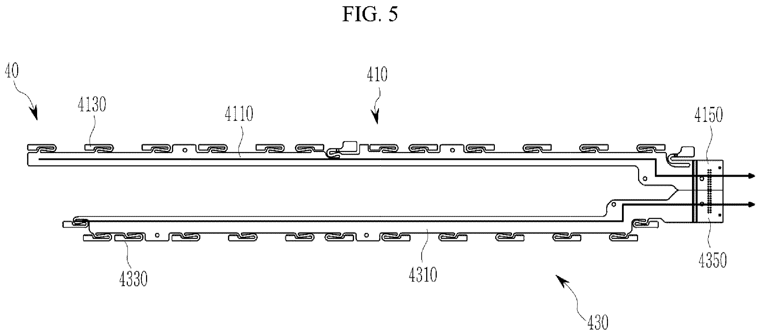

FIG. 4 illustrates a cross-sectional view of a portion of the flexible printed circuit board assembly 40, and FIG. 5 illustrates an information transmission path in the flexible printed circuit board assembly 40. FIG. 4 illustrates a partial cross-sectional view of either the first substrate 410 or the second substrate 430.

Referring to FIG. 4, the flexible printed circuit board assembly 40 may include a base film 401, an adhesive layer 403, and a circuit pattern layer 405. An adhesive layer 403 may be applied on the base film 401, and a circuit pattern layer 405 may be arranged on the adhesive layer 403.

In one or more embodiments, the circuit pattern layer 405 and the base film 401 may be connected through the adhesive layer 403. The base film 401 may be made of a material with excellent flexibility and insulating properties. For example, the base film 401 may be made of polyimide (PI).

In one or more embodiments, the flexible printed circuit board assembly 40 may further include an insulating layer 407 covering the circuit pattern layer 405. In one or more embodiments, an additional adhesive layer 403' may be applied again while the circuit pattern layer 405 is positioned, or situated, to flatten the insulating layer 407. Then, the insulating layer 407 may be placed thereon.

The flexible printed circuit board assembly 40 according to one or more embodiments of the present disclosure may have a single-layer structure in which the circuit pattern layer 405 is arranged at a first side of the base film 401.

Referring to FIG. 5, it may be confirmed that information related to battery cells transmitted to the outside through the flexible printed circuit board assembly 40 is transmitted to the outside through each of the connectors 4150 and 4350 through each of the branch lines 4130 and 4330 of the first and second substrates 410 and 430 of the flexible printed circuit board assembly 40 (refer to an arrow direction illustrated in FIG. 5).

If manufacturing a flexible printed circuit board with a single size of width, as in a general flexible printed circuit board, circuit pattern layers may be manufactured in multiple layers, for example, at least two layers, to obtain information from the positive electrode terminals of the battery cell, and to transmit the information to the outside.

However, the flexible printed circuit board assembly 40 according to one or more embodiments of the present disclosure may simplify a signal transmission path by partitioning the flexible printed circuit board assembly 40 into multiple substrates (e.g., into two), and by electrically connecting the divided substrates, by configuring the circuit pattern layer 405 (see FIG. 4) provided on the substrate as a single layer.

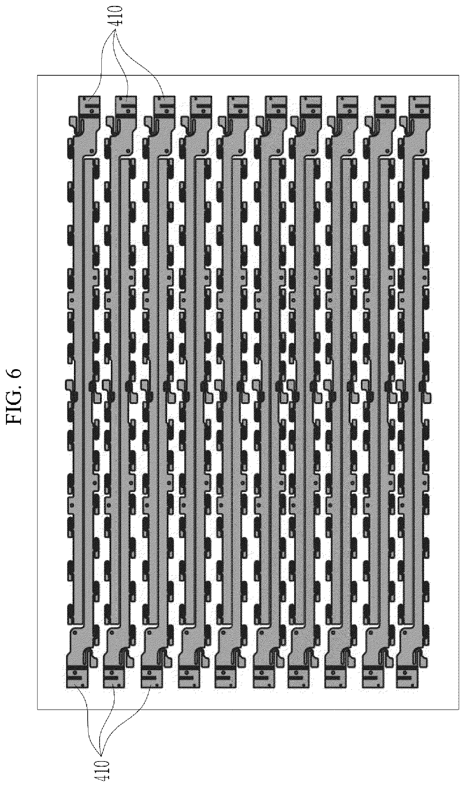

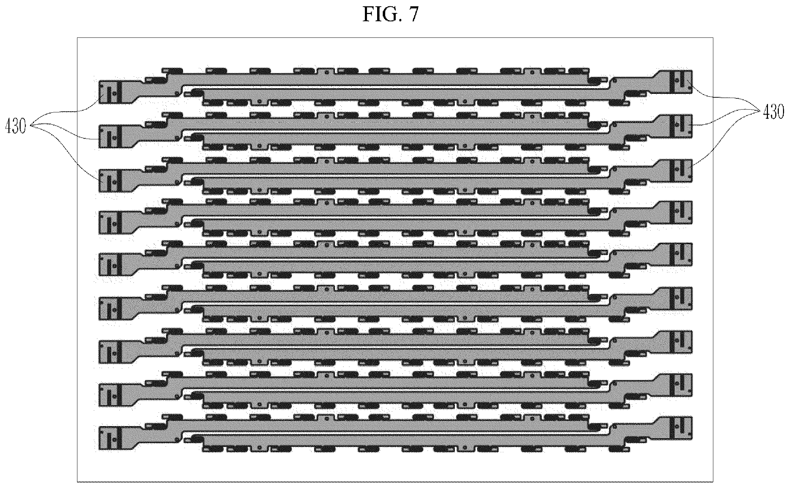

FIGS. 6 and 7 illustrate schematic views for describing numbers of first substrates 410 and second substrates 430 that can be manufactured from a material (e.g., base film) having a corresponding size according to one or more embodiments of the present disclosure. FIG. 6 illustrates a view for describing the number of first substrates 410, and FIG. 7 illustrates a view for describing the number of second substrates 430.

Referring to FIG. 6, the first substrate 410 may be manufactured by arranging pairs of the same (e.g., similarly configured) first substrate 410 alternately inverted (e.g., with respect to up, down, left, and right directions). For example, two first substrates 410 may be inverted with respect to one another and arranged to face each other. Pairs of first substrates 410 may be arranged sequentially while maintaining the same pattern. If the first substrates 410 are arranged in this way, a space between a pair of first substrates 410, as well as between adjacent pairs, may be reduced or minimized.

In FIG. 6, it is illustrated that twenty of the first substrates 410 may be manufactured from a material of a corresponding size. However, in one or more embodiments, a number of first substrates 410 manufactured may vary depending on a size of the material.

Referring to FIG. 7, the second substrate 430 may also be manufactured by arranging two second substrates 430 facing each other with respective upper, lower, left, and right sides reversed from one another. A material for the second substrate 430 illustrated in FIG. 7 has a same size as a material for the first substrate 410 illustrated in FIG. 6. The second substrate 430 of this material may be manufactured by arranging it with a same pattern as that of the first substrate 410. In one or more embodiments corresponding to FIG. 7, a total of eighteen second substrates 430 may be manufactured, and the number of second substrates 430 manufactured may also vary depending on a size of the material, similar to the first substrate 410.

To manufacture one flexible printed circuit board assembly 40, one first substrate 410 and one second substrate 430 may be used. In one or more embodiments, the first substrate 410 and the second substrate 430 capable of forming a total of eighteen flexible printed circuit board assemblies 40 with two materials may be manufactured, and two additional first substrates 410 may be manufactured.

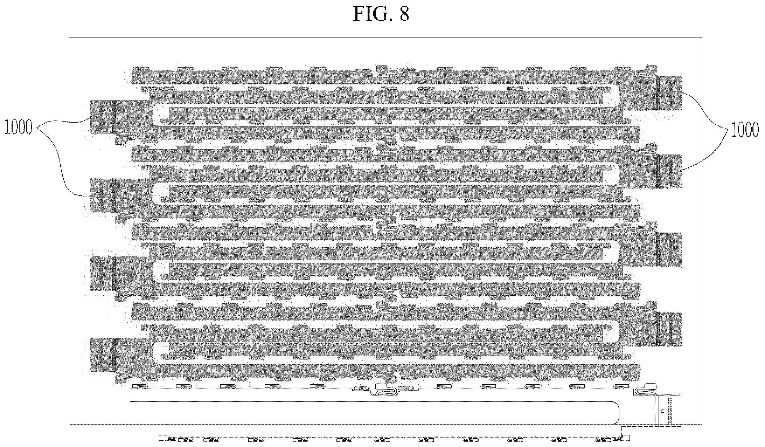

FIG. 8 illustrates a schematic view for describing the number of general flexible printed circuit boards 1000 that can be manufactured with one material. The flexible printed circuit board 1000 illustrated in FIG. 8 corresponds to one or more embodiments where first and second substrate portions of a flexible printed circuit board assembly are integrally made. In one or more embodiments, a material for the flexible printed circuit board 1000 illustrated in FIG. 8 was set to have a same size as that of the material illustrated in FIGS. 6 and 7.

As may be seen from FIG. 8, a space is provided in which about 8.5 flexible printed circuit boards 1000 may be arranged in one material, and through this, it may be seen that the number of flexible printed circuit boards 1000 that can be practically manufactured is 8.

In a case of such flexible printed circuit boards 1000, it may be seen that if a space is not provided to manufacture a complete flexible printed circuit board 1000 using a single material for manufacturing, the space may be wasted or not optimized.

It may be seen that, unlike embodiments of the present disclosure, the flexible printed circuit board 1000 does not efficiently use the space of the material at a manufacturing process, and causes more wasted space than caused if manufacturing the flexible printed circuit board assembly 40 according to the present disclosure. Accordingly, a number of products that can be manufactured may decrease, and a manufacturing cost may increase.

For example, by comparing the number of manufactured general flexible printed circuit boards 1000 and the flexible printed circuit board assemblies 40 according to embodiments of the present disclosure, it may be confirmed that a total of eighteen flexible printed circuit board assemblies 40 may be manufactured with two materials of a same size, two more extra first substrates 410 may be manufactured, and only a total of 16 general flexible printed circuit boards 1000 may be manufactured.

In one or more embodiments, it may be seen that 12.5% more flexible printed circuit boards capable of performing a same role may be manufactured, and additionally, up to the first substrate 410 may be manufactured.

In one or more embodiments, the first substrate 410 and the second substrate 430 constituting the flexible printed circuit board assembly 40 may be manufactured separately, thereby reducing or minimizing waste space that may occur in the material during the manufacturing stage. One or more embodiments may improve manufacturing efficiency, and may lead to cost reduction.

### Flexible printed circuit board assembly manufacturing method

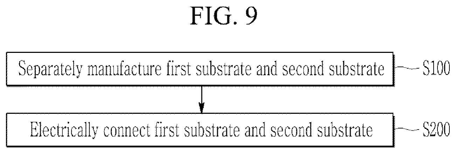

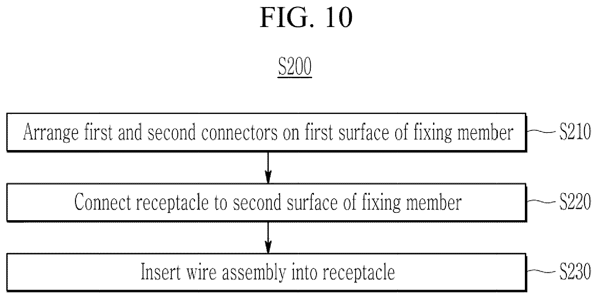

FIG. 9 and FIG. 10 illustrate a flowchart for describing a manufacturing method for the flexible printed circuit board assembly 40 according to one or more embodiments of the present disclosure.

Referring to FIG. 9, a manufacturing method for the flexible printed circuit board assembly 40 may include an operation S100 of separately manufacturing the first substrate 410 and the second substrate 430.

By manufacturing the first substrate 410 and the second substrate 430 separately, as described above, the waste space that may occur during the manufacturing process of each of the substrates 410 and 430 may be reduced or minimized, and thus numbers of manufactured first substrates 410 and second substrates 430 may be increased.

A method for manufacturing the flexible printed circuit board assembly 40 may further include an operation S200 of electrically connecting the first substrate 410 and the second substrate 430. The first substrate 410 and the second substrate 430 may be interconnected to be used as a single flexible circuit board.

Referring to FIG. 10, the operation S200 of electrically connecting the first substrate 410 and the second substrate 430 may include an operation S210 of arranging the first connector 4150 and the second connector 4350 on a first surface of the fixing member 450.

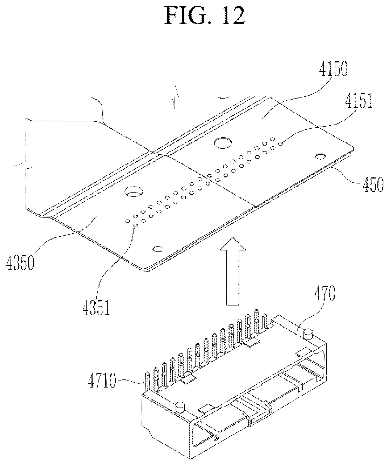

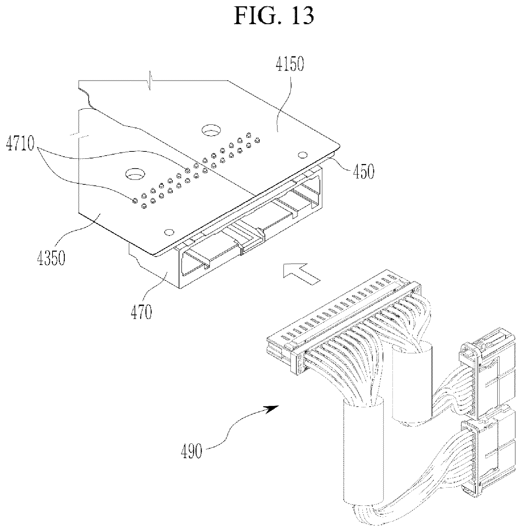

In one or more embodiments, the operation S200 of electrically connecting the first substrate 410 and the second substrate 430 may further include an operation S220 of connecting the receptacle 470 to a second surface of the fixing member 450, and an operation S230 of inserting the wire assembly 490 into the receptacle 470. Each of the operations will be described in detail with reference to FIGS. 12 and 13.

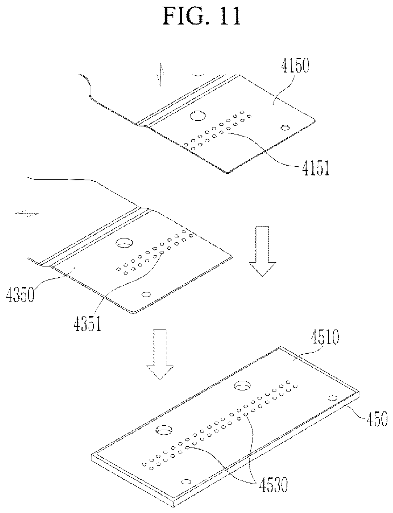

FIG. 11 is a view illustrating an operation S210 of arranging the first connector 4150 and the second connector 4350 on the first surface of the fixing member 450. In one or more embodiments, the first substrate 410 and the second substrate 430 may be arranged adjacently.

The adhesive 4510 may be coated on the first surface of the fixing member 450. In one or more embodiments, the adhesive 4510 may be provided between the first surface of the fixing member 450 and each of the connectors 4150 and 4350. If each of the connectors 4150 and 4350 is positioned on the first surface of the fixing member 450, a position of each of the connectors 4150 and 4350 may be fixed.

The fixing member 450 may be a rigid printed circuit board (PCB). The fixing member 450 has strong rigidity compared to the flexible first substrate 410 and second substrate 430, so that the position of each of the connectors 4150 and 4350 may be appropriately fixed, and deformation of each of the connectors 4150 and 4350 may be reduced or prevented.

The fixing member 450 may have a shape that combines a shape of the first connector 4150 and a shape of the second connector 4350, and each of the connectors 4150 and 4350 may be positioned on the fixing member 450. For example, the fixing member 450 may include a body having a roughly rectangular shape. The body is provided with a throughhole 4530 having a same shape and number as those of the perforation 4151 of the first connector 4150 and the perforation 4351 of the second connector 4350. In one or more embodiments, the perforations 4151 and 4351 and the throughholes 4530 may overlap, thereby allowing the flexible printed circuit board assembly 40 to have an opening extending from the second surface of the fixing member 450 to the upper surface of each of the connectors 4150 and 4350.

FIG. 12 is a view illustrating an operation S220 of connecting the receptacle 470 to the second surface of the fixing member 450. The receptacle 470 may have a plurality of pins 4710 arranged to correspond to positions of the throughholes 4530 and the perforations 4151 and 4351, and the pins 4710 may be received through the throughholes 4530 and the perforations 4151 and 4351.

The pins 4710 may be made of a conductive material. In one or more embodiments, if the pins 4710 come into contact with the conductive material plated inside each throughhole 4530, a current may flow between each of the first substrate 410, the second substrate 430, and the receptacle 470.

FIG. 13 is a view illustrating an operation S230 of inserting the wire assembly 490 into the receptacle 470. Referring to FIG. 13, the pins 4710 of the receptacle 470 may protrude partially across from the second surface of the fixing member 450 to an upper surface of each of the connectors 4150 and 4350.

In one or more embodiments, a connection relationship between the first connector 4150 and the second connector 4350 may be fixed by welding, and the first substrate 410 and the second substrate 430 may be electrically connected to each other. However, any method that can be used to make an electrical connection between metals, including welding, may be used without limitation.

In one or more embodiments, if the wire assembly 490 is accommodated in the receptacle 470, the flexible printed circuit board assembly 40 may be electrically connected to an external device connected to a second surface of the wire assembly 490.

The flexible printed circuit board assembly 40 may be manufactured in a single-layer structure so that information related to battery cells received from each of the branch lines 4130 and 4330 may be transmitted to the outside (e.g., to an external component) through the wire assembly 490 without crossing at each of the connectors 4150 and 4350.

In one or more embodiments, information related to the battery cells received from the first branch line 4130 may be transmitted to an outside by a portion of the pin 4710 received in the first connector 4150 and a perforation 4151 thereof, and information related to the battery cells received from the second branch line 4330 may be transmitted to the outside by a portion of the pin 4710 received in the second connector 4350 and a perforation thereof 4351.

In one or more embodiments, wires connected to the first substrate 410 may be organized into one bundle, and wires connected to the second substrate 430 may be organized into another bundle.

While this disclosure has been described in connection with what is presently considered to be practical embodiments, it is to be understood that the disclosure is not limited to the disclosed embodiments, but, on the contrary, is intended to cover various modifications and equivalent arrangements included within the scope of the appended claims.

**Description of Some of the Reference Characters**

| | | | |
|---|---|---|---|
| 1: | busbar assembly | 10: | busbar holder |
| 20: | busbar | 30: | center busbar |
| 40: | flexible printed circuit board assembly | 110: | first opening |
| 130: | second opening | 200: | battery cell |
| 210: | electrode terminal | 230: | vent |
| 401: | base film | 403: | adhesive layer |
| 405: | pattern forming layer | 407: | insulating layer |
| 410: | first substrate | 430: | second substrate |
| 450: | fixing member | 470: | receptacle |
| 490: | wire assembly | 2000: | battery module |
| 4110: | first main line | 4130: | first branch line |
| 4150: | first connector | 4151: | perforation |
| 4310: | second main line | 4330: | second branch line |
| 4350: | second connector | 4351: | perforation |
| 4510: | adhesive | 4530: | throughhole |
| 4710: | pin | | |

## Claims

1. A flexible printed circuit board assembly (40) comprising:
a first substrate (410) comprising:
a first main line (4110);
a first branch line (4130) extending from the first main line; and
a first connector (4150) at a first side of the first main line, and having a perforation (4151); and
a second substrate (430) separated from the first substrate (410), and comprising:
a second main line (4310);
a second branch line (4330) extending from the second main line; and
a second connector (4350) at a first side of the second main line, and having a perforation (4351),
wherein the first substrate (410) and the second substrate (430) are electrically connected through the first connector (4150) and the second connector (4350).

2. The flexible printed circuit board assembly as claimed in claim 1, further comprising a receptacle (470) comprising pins (4710) configured to be received in the perforation (4151) of the first connector (4150) and in the perforation (4351) of the second connector (4350).

3. The flexible printed circuit board assembly as claimed in claim 2, further comprising a fixing member (450) having a first surface on which the first connector (4150) and the second connector (4350) are arranged, and a second surface to which the receptacle (470) is connected.

4. The flexible printed circuit board assembly as claimed in claim 3, wherein the fixing member (450) comprises a rigid printed circuit board.

5. The flexible printed circuit board assembly as claimed in claim 3 or claim 4, wherein the fixing member (450) comprises an adhesive (403) between the fixing member (450) and the first connector (4150), and between the fixing member (450) and the second connector (4350).

6. The flexible printed circuit board assembly as claimed in any one of claims 3 to 5, wherein the fixing member (450) defines throughholes (4530) corresponding to the perforation (4151, 4351) of the first and second connectors (4150, 4350), and
wherein the pins (4710) extend through the throughholes beyond the first connector (4150) and the second connector (4350).

7. The flexible printed circuit board assembly as claimed in any one of claims 1 to 6, wherein the first substrate (410) and the second substrate (430) comprise:
a base film (401) having an insulating property and flexibility; and
a circuit pattern layer (405) on a first surface of the base film.

8. The flexible printed circuit board assembly as claimed in any one of claims 2 to 6, further comprising a wire assembly (490) in the receptacle (470).

9. A battery module (2000) comprising a plurality of battery cells (200), a busbar (20) arranged on the battery cells and a flexible printed circuit board assembly (40) according to any one of claims 1 to 8 electrically connected to the busbar (20).

10. A manufacturing method for a flexible printed circuit board assembly (40), the method comprising:
separately manufacturing a first substrate (410) comprising a first connector (4150) at a first side, and a second substrate (430) comprising a second connector (4350) at a first side; and
electrically connecting the first substrate (410) and the second substrate (430) through the first connector (4150) and the second connector (4350).

11. The manufacturing method as claimed in claim 10, wherein the electrically connecting the first substrate (410) and the second substrate (430) comprises:
arranging the first connector (4150) and the second connector (4350) on a first surface of a fixing member (450); and
connecting a receptacle (470) to a second surface of the fixing member (450).

12. The manufacturing method as claimed in claim 11, wherein the electrically connecting the first substrate (410) and the second substrate (430) further comprises inserting a wire assembly (490) into the receptacle (470).
